# EUROPÄISCHE PATENTSCHRIFT

(11) **EP 2 030 490 B1**
(45) Veröffentlichungstag und Bekanntmachung des Hinweises auf die Patenterteilung: **06.07.2016**
(21) Anmeldenummer: 07725418.3
(22) Anmeldetag: 22.05.2007
(51) Int. Cl.: H01J 37/32, H05H 1/50

(54) **VERFAHREN UND VORRICHTUNG ZUM ERZEUGEN EINES PLASMAS SOWIE VERWENDUNG DERSELBEN**
METHOD AND APPARATUS FOR GENERATING A PLASMA AND USE OF THE SAME
PROCÉDÉ ET DISPOSITIF DE GÉNÉRATION DE PLASMA ET LEUR UTILISATION

(30) Priorität: 16.06.2006 DE 102006027853
(43) Veröffentlichungstag der Anmeldung: 04.03.2009
(73) Patentinhaber: Fraunhofer-Gesellschaft zur Förderung der angewandten Forschung e.V., 80686 München (DE)
(72) Erfinder: FIETZKE, Fred, 01728 Hänichen (DE); GOEDICKE, Klaus, 01307 Dresden (DE); FLASKE, Henrik, 01157 Dresden (DE); LIEBIG, Jörn-Steffen, 01328 Dresden (DE); KIRCHHOFF, Volker, 01324 Dresden (DE)
(86) Internationale Anmeldenummer: PCT/EP2007/004512
(87) Internationale Veröffentlichungsnummer: WO 2007/144061

(56) Entgegenhaltungen:
- WO-A2-2006/003374
- DE-A1- 19 546 827
- DE-A1- 19 625 539
- US-A- 4 682 564
- US-A1- 2001 020 582

## Beschreibung

Die Erfindung betrifft ein Verfahren und eine Vorrichtung zum Erzeugen eines Niederdruckplasmas. Derartige Plasmen werden vorwiegend bei Prozessen der vakuumgestützten physikalischen Dampfabscheidung (physical vapor deposition - PVD) zur Erzeugung dünner Schichten mit speziellen Funktionen auf der Oberfläche von Bauteilen oder flächig ausgebreiteten Substraten wie Folien, Platten oder Scheiben und beim Vorbehandeln von Substratoberflächen verwendet.

### Stand der Technik

Das Erzeugen von Niederdruckplasmen mittels Hohlkathoden-Entladungen ist seit den 20er Jahren des vorigen Jahrhunderts bekannt, wobei stromstarke Hohlkatoden-Bogenentladungen erst im Verlaufe der 60er Jahre beherrschbar wurden. Hauptanwendungsgebiete wurden zunächst in Technologien wie Ionentriebwerken und MHD-Generatoren vermutet. Erste Anwendungen in der zu dieser Zeit stark aufkommenden Vakuum-Bedampfungstechnik nutzten die Energie des Niedervolt-Elektronenstrahls einer Hohlkathoden-Bogenentladung zum direkten Verdampfen von Metallen (US 3,562,141 A). Erstmals wurden hier auch Magnetspulen zum Fokussieren und Umlenken eines Elektronenstrahls eingesetzt. Da auf diesem Gebiet jedoch mit den Hochspannungs-Elektronenstrahl-Erzeugern bereits leistungsfähige Werkzeuge zur Verfügung standen, blieb der Einsatz von Hohlkathoden-Verdampfern in der industriellen Praxis auf sehr wenige Fälle beschränkt (EP 0 278 494 A2).

Anders sieht es dagegen beim Einsatz von Hohlkathoden-Bogenentladungen zur Plasmaerzeugung aus. Hier können die Vorteile dieses Entladungstyps, wie niedrige Brennspannung und hoher extrahierbarer Strom, voll zum Tragen gebracht und mit anderen Verfahren nur schwer zu erreichende Plasmadichten erzeugt werden. Besonders bewährt hat sich eine Kombination aus Hochspannungs-Elektronenstrahl-Verdampfung und Plasmaaktivierung mittels Hohlkathoden-Bogenentladung (DE 42 35 199 C1). Dieses Grundprinzip wurde mehrfach weiterentwickelt und modifiziert, wobei zum Teil auch ringförmige Zündanoden und die Hohlkathode durchdringende Magnetfelder vorgeschlagen wurden. So ist aus DE 103 18 363 A1 eine plasmaaktivierte Hochrate-Bedampfungseinrichtung bekannt, bei welcher mittels eines Magnetfeldes zwischen einem Verdampfungsgut und einem zu beschichtenden Substrat Ionen in Richtung Substrat beschleunigt werden.
DE 195 46 827 A1 schlägt vor, mittels eines eine Hohlkathode umgebenden Magnetfeldes den die Hohlkathode verlassenden Elektronenstrahl zu fokussieren und zu führen.

Allen diesen Einrichtungen ist jedoch gemeinsam, dass diese nur mit relativ großen Gasflüssen von 50 bis 200 sccm durch jede Hohlkathode stabil betrieben werden können. Während die Brennspannung mit steigendem Gasfluss und konstant gehaltenem Entladungsstrom deutlich abfällt, ist im Allgemeinen lediglich eine schwache Abhängigkeit der erzielbaren Plasmadichte vom Gasfluss feststellbar. So nimmt mit steigenden Gasflüssen die Plasmadichte nur leicht zu und ist aufgrund des Strahl-Charakters der Entladung noch dazu extrem inhomogen verteilt. Aus diesem Grund ist für eine kontinuierliche Beschichtung von Substraten großer Breite das parallele Betreiben von bis zu 10 Hohlkathoden notwendig. Die Summation der zum Betreiben all dieser Hohlkathoden notwendigen Gasflüsse durch die Hohlkathoden in eine Vakuumarbeitskammer stellt jedoch schnell unerfüllbare Anforderungen an die zu installierenden Hochvakuumpumpen, um die erforderlichen Vakuumbedingungen innerhalb der Vakuumarbeitskammer aufrecht zu halten.

### Aufgabenstellung

Der Erfindung liegt daher das technische Problem zugrunde, ein Verfahren und eine Vorrichtung zum Erzeugen eines Niederdruckplasmas mittels einer Hohlkathoden-Bogenentladung zu schaffen, mit denen die dargestellten Nachteile des Standes der Technik überwunden werden. Insbesondere sollen es Verfahren und Vorrichtung ermöglichen, gegenüber dem Stand der Technik deutlich höhere Plasmadichten zu realisieren. Weiterhin sollen eine homogenere Verteilung des Plasmas in der umgebenden Vakuumarbeitskammer erzielt und die erforderlichen Vakuumbedingungen in der Vakuumarbeitskammer ohne erhöhten Aufwand aufrechterhalten werden.

Die Lösung des technischen Problems ergibt sich durch die Gegenstände mit den Merkmalen der Patentansprüche 1 und 12. Weitere vorteilhafte Ausgestaltungen der Erfindung ergeben sich aus den abhängigen Patentansprüchen.

Gegenüber der bekannten Praxis, die Dichte eines Hohlkathoden-Bogenentladungsplasmas in einer Vakuumarbeitskammer zu erhöhen, indem der Gasfluss durch die Hohlkathode erhöht und somit die Anzahl ionisierbarer Atome erhöht wird, wurde überraschend festgestellt, dass das Verringern des Gasflusses durch die Hohlkathode zu einem drastischen Anstieg des lonenstromes (welcher ein Maß für die Dichte eines Plasmas darstellt) in der Vakuumarbeitskammer führt, wenn sich hierbei die Hohlkathode in einem Magnetfeld mit geeigneter Form und hinreichend großer Stärke befindet und die Gegenelektrode für die Bogenentladung eine entsprechende Gestaltungsform aufweist.

Bei einem erfindungsgemäßen Verfahren zum Erzeugen eines Plasmas in einer Vakuumarbeitskammer wird daher zunächst eine Bogenentladung zwischen einer Hohlkathode und einer Anode gezündet, wobei die Hohlkathode in einem Magnetfeld angeordnet wird, welches zumindest in einem die Hohlkathode durchdringenden Bereich mit Feldlinien ausgebildet wird, die im Wesentlichen parallel zur Hohlkathodenachse verlaufen. Dabei ist die Anode derart auszubilden, dass diese die Hohlkathode zumindest elektronenaustrittsseitig umschließt. Nachfolgend ist die Stärke des Magnetfeldes so hoch einzustellen, dass durch Verringern des Flusses eines die Hohlkathode durchströmenden Gases die Plasmadichte in der Vakuumarbeitskammer erhöht wird.

Die erforderliche Mindeststärke des Magnetfeldes ist abhängig von der jeweiligen Ausgestaltungsform von Hohlkathode, Anode und deren Position zueinander. Ein positiver Effekt bezüglich des Erhöhens der Plasmadichte in einer Vakuumarbeitskammer konnte bereits bei einer die Hohlkathode durchdringenden Magnetfeldstärke von 1 kA/m festgestellt werden. Ein weiterer Qualitätssprung beim Erhöhen der Plasmadichte ist mit Magnetfeldstärken oberhalb von 10 kA/m realisierbar. Allgemein kann festgehalten werden, dass bei erfindungsgemäßer Vorgehensweise mit zunehmender Magnetfeldstärke auch der Ionenstrom und somit gleichfalls die Plasmadichte in der Vakuumarbeitskammer erhöht werden kann. Als weiterer Effekt erhöht sich auch die Brennspannung mit steigender Magnetfeldstärke.

Wie stark der Gasfluss durch die Hohlkathode verringert werden muss, um eine erwünschte Plasmadichte zu erlangen, ist ebenfalls von der Konfiguration einer verwendeten Hohlkathode und der jeweiligen Aufgabenstellung abhängig. Ein Anstieg des Ionenstromes kann bereits bei einer Reduktion des Gasflusses auf 40 sccm ermittelt werden. Ein weiteres Verringern des Gasflusses führt zu einem weiteren dynamischen Anstieg des Ionenstromes, wobei unterhalb eines Gasflusses von 20 sccm bereits eine Vervielfachung des Ionenstromes bezogen auf den anfänglichen Ionenstrom bei einem nicht reduzierten Gasfluss nach dem Stand der Technik erzielt werden kann.

Bei Anwendung des erfindungsgemäßen Verfahrens bietet sich einem durch ein Fenster in der Vakuumkammer schauenden Beobachter der Anblick einer intensiven, milchig-hellen Leuchterscheinung, die große Teile der Vakuumkammer nahezu gleichmäßig erfüllt. Plasmen, die mit dem erfindungsgemäßen Verfahren erzeugt werden, sind daher besonders geeignet zum Vorbehandeln (beispielsweise Plasmaätzen) großflächiger Substratoberflächen bzw. können vorteilhaft bei plasmaunterstützten Vakuumbeschichtungsprozessen (Sputtern, Bedampfen) von großflächigen Substraten eingesetzt werden.

Vorteilhaft wirkt sich hierbei aus, dass erfindungsgemäß erzeugte Plasmen zum einen ein größeres Volumen aufweisen gegenüber Plasmen, die nach bekannten Verfahren erzeugt wurden, und zum anderen in der Dichteverteilung gleichmäßiger ausgebildet sind. Eine umfassende wissenschaftliche Erklärung der beobachteten Zusammenhänge ist bisher nicht möglich. Interpretationen in Richtung Erhöhung der Stoßwahrscheinlichkeit der aus der Hohlkathode emittierten Elektronen durch Gyrationsbewegungen im Magnetfeld oder durch resonante Wechselwirkung mit dem Plasma wären denkbar.

Für das Erzeugen eines,Plasmas müssen in einer Vakuumarbeitskammer ionisierbare Teilchen (Atome, Moleküle) zur Verfügung stehen, welche bei einem Hohlkathoden-Bogenentladungsplasma durch den Fluss eines Gases durch die Hohlkathode in die Vakuumkammer bereitgestellt werden. Da beim erfindungsgemäßen Verfahren der Gasfluss in die Vakuumkammer und somit die Anzahl zur Verfügung stehender ionisierbarer Teilchen reduziert wird, kann es erforderlich sein, zusätzlich ionisierbare Teilchen in der Vakuumkammer bereitzustellen. Dies kann beispielsweise durch einen zusätzlichen zweiten Gasfluss in die Vakuumkammer realisiert werden, wobei zum Beispiel ein Inertgas (beispielsweise Argon) oder/und ein Reaktivgas (beispielsweise Sauerstoff) in die Vakuumkammer eingelassen werden kann/können.

Ist das erfindungsgemäße Verfahren Bestandteil eines plasmaaktivierten Beschichtungsprozesses (Sputtern, Bedampfen), so ist ein zusätzlicher Gaseinlass in die Vakuumkammer nicht unbedingt erforderlich, weil hierbei beispielsweise durch das Zerstäuben oder Verdampfen eines Materials weitere ionisierbare Teilchen bereitgestellt werden.

Eine erfindungsgemäße Vorrichtung zum Erzeugen eines Plasmas in einer Vakuumarbeitskammer umfasst eine Hohlkathode und eine Anode, zwischen denen eine Hohlkathoden-Bogenentladung erzeugbar ist. Dabei befindet sich die Hohlkathode in einem Magnetfeld, welches zumindest in einem die Hohlkathode durchdringenden Bereich Feldlinien aufweist, die im Wesentlichen parallel zu Hohlkathodenachse verlaufen. Die Anode ist derart ausgebildet und angeordnet, dass diese die Hohlkathode zumindest elektronenaustrittsseitig umschließt. Ferner umfasst die erfindungsgemäße Vorrichtung eine Einrichtung, mittels der der Fluss eines Gases durch die Hohlkathode gezielt verringerbar ist. Bei einer hinreichend großen Magnetfeldstärke ist mittels dieser Einrichtung der Gasfluss durch die Hohlkathode so weit verringerbar, dass dadurch die Plasmadichte in der Vakuumarbeitskammer erhöht wird.

Bei einer Ausführungsform ist die Anode als Zylinder ausgebildet.

Bei einer weiteren Ausführungsform ist die magnetfelderzeugende Einrichtung zylinderförmig ausgebildet, wobei als magnetfelderzeugende Einrichtung Magnetspulen oder/und Permanentmagnete verwendet werden können.

Bei einer bevorzugten Ausführungsform sind zylinderförmig ausgebildete Anode und zylinderförmig ausgebildete magnetfelderzeugende Einrichtung derart angeordnet, dass die Achsen beider Zylinder mit der Achse der Hohlkathode identisch sind. Die Form eines aus einer derartigen Vorrichtung resultierenden Plasmas oder/und dessen Position innerhalb einer Vakuumarbeitskammer kann verändert werden, indem beispielsweise die Achsen von Anode, magnetfelderzeugender Einrichtung und/oder Hohlkathode zueinander parallelverschoben oder/und mit einem Winkel zueinander angeordnet werden.

Eine weitere bevorzugte Ausführungsform ist dadurch charakterisiert, dass die magnetfelderzeugende Einrichtung in oder an der Anode angeordnet ist. Bei einer derartigen Anordnung erzeugt die magnetfelderzeugende Einrichtung Feldlinien, welche die Anode einschließen, wodurch das Magnetfeld gleichzeitig eine Schirmfunktion für die Anode gegenüber Elektronen ausübt.

Umfasst eine erfindungsgemäße Vorrichtung Mittel, mit denen Hohlkathode, Magnetfeld und Anode relativ zur Vakuumarbeitskammer bewegbar sind, so lassen sich auch größere Substratoberflächen mit dem erzeugten Plasma überstreichen.

Eine erfindungsgemäße Vorrichtung kann verwendet werden beim Vorbehandeln von Substratoberflächen (beispielsweise beim Plasmaätzen oder beim Aktivieren von Oberflächen) und ist ebenfalls geeignet für den Einsatz bei plasmaaktivierten Beschichtungsaufgaben, bei denen Oberflächen mittels Sputtern oder Bedampfen beschichtet werden.

Die Erfindung wird nachfolgend anhand eines bevorzugten Ausführungsbeispiels näher erläutert. Die Fig. zeigen:
- Fig. 1: eine schematische Darstellung einer erfindungsgemäßen Vorrichtung;
- Fig. 2: eine graphische Darstellung der Abhängigkeit der Hohlkathodenspannung in Abhängigkeit vom Hohlkathoden-Gasdurchfluss;
- Fig. 3: eine graphische Darstellung der Abhängigkeit des Ionenstromes in Abhängigkeit vom Hohlkathoden-Gasdurchfluss.

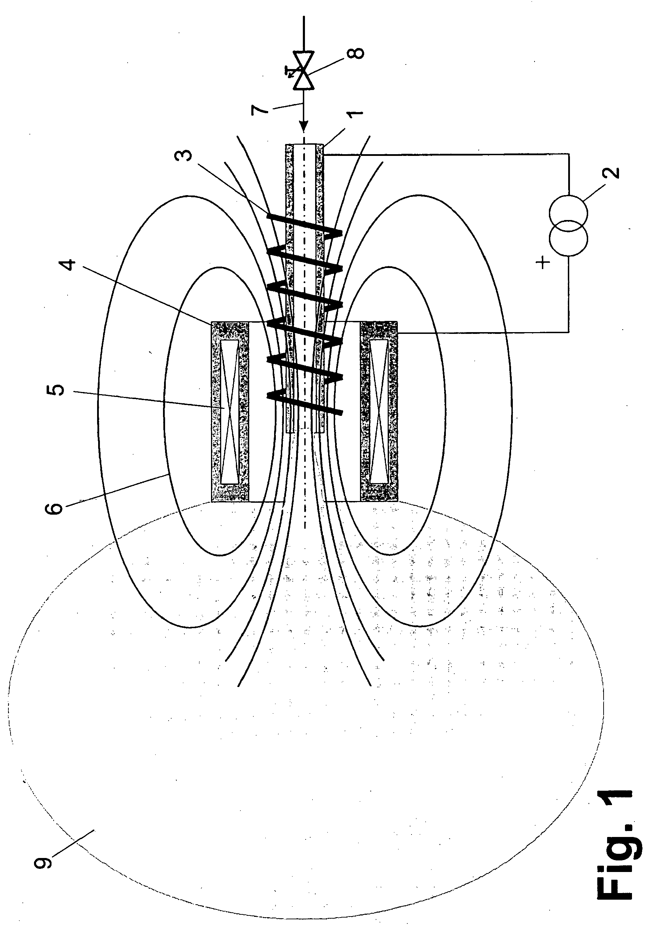

In Fig. 1 ist schematisch eine Vorrichtung zum Erzeugen eines Plasmas in einer nicht dargestellten Vakuumarbeitskammer dargestellt. Eine Hohlkathode 1 wird mit Hilfe einer Stromversorgungseinrichtung 2 gezündet und betrieben. Um die zum stabilen Betrieb notwendige Temperatur von mehr als 2000 °C zu erreichen, ist die Hohlkathode 1 von einer Heizwendel 3 umschlungen, welche nach dem Erreichen dieser Betriebstemperatur abgeschaltet werden kann. Der vordere Teil von Hohlkatode 1 und Heizwendel 3 ist von einer als Anode ausgebildeten Gegenelektrode 4 in Form eines Hohlzylinders umgeben. Dabei ist die Gegenelektrode 4 rotationssymmetrisch um die Achse von Hohlkatode 1 angeordnet. Im Inneren der Gegenelektrode 4 befindet sich eine Drahtspule 5. Von einem elektrischen Strom der Stärke 10 A durchflossen dient Drahtspule 5 zum Erzeugen eines Magnetfeldes 6, welches sowohl die Hohlkatode 1 als auch den die Hohlkathode 1 umgebenden Raum durchdringt. Dabei weist das Magnetfeld 6 im vorderen Bereich der Hohlkathode 1, in dem Elektronen die Hohlkathode 1 verlassen, Magnetfeldlinien auf, die im Wesentlichen parallel zur Achse der Hohlkathode 1 verlaufen, wobei Magnetfeldlinien mit gleicher Magnetfeldstärke rotationssymmetrisch um diese Achse angeordnet sind.

Durch die Hohlkatode 1 wird ein einstellbarer Gasfluss 7 des Inertgases Argon in die Vakuumkammer eingelassen. Nach einer Reduktion dieses Gasflusses 7 mittels eines Ventils 8 unter den Wert von 30 sccm erfüllt ein hell leuchtendes Plasma 9 nahezu die gesamte Vakuumkammer, wobei eine weitere Reduktion des Gasflusses 7 eine Zunahme der Leucht-Intensität bewirkt, welche gleichzeitig eine Zunahme der Plasmadichte veranschaulicht.

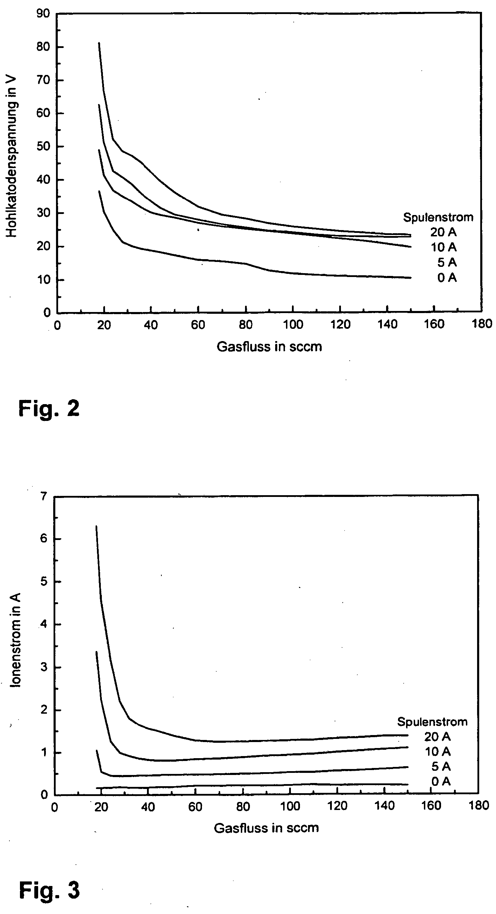

Die Abhängigkeit der Spannung von Hohlkathode 1 in Abhängigkeit vom Gasdurchfluss 7 durch Hohlkathode 1 bei verschiedenen elektrischen Strömen durch Drahtspule 5 ist in Fig. 2 graphisch dargestellt, wobei zunehmende elektrische Ströme durch Drahtspule 5 gleichbedeutend sind mit einer Zunahme der Feldstärke des von Drahtspule 5 erzeugten magnetischen Feldes 6.

Fig. 3 veranschaulicht graphisch die Abhängigkeit des in der Vakuumkammer ermittelten Ionenstromes in Abhängigkeit vom Gasfluss 7 durch Hohlkathode 1, ebenfalls wieder bei verschiedenen elektrischen Strömen durch Drahtspule 2, wobei Aussagen über das Verändern des Ionenstromes äquivalente Aussagen über das Verändern der Plasmadichte liefern. Aus Fig. 3 ist zu erkennen, dass bei geeigneter Magnetfeldstärke das Verringern des Hohlkathodengasdurchflusses 7 unter 30 sccm einen dynamischen Anstieg des lonenstromes bewirkt, wobei hierbei ein Ionenstrom und somit auch eine Plasmadichte erreichbar ist, der/die um ein Vielfaches höher ist als bei Verfahren nach dem Stand der Technik, bei denen der Hohlkathodengasdurchfluss erhöht wurde, um in dessen Ergebnis eine nur wenig höhere Plasmadichte zu erzielen, wie es auch in Fig. 3 im Bereich zwischen 60 und 150 sccm ablesbar ist.

## Patentansprüche

1. Verfahren zum Erzeugen eines Plasmas (9) und zum Erhöhen der Dichte eines Plasmas (9) in einer Vakuumarbeitskammer, in welcher eine Bogenentladung zwischen einer Hohlkathode (1) und einer Anode (4) erzeugt und die Hohlkathode (1) in einem Magnetfeld (6) angeordnet wird, welches zumindest in einem die Hohlkathode (1) durchdringenden Bereich mit Feldlinien ausgebildet wird, die im Wesentlichen parallel zur Hohlkathodenachse verlaufen, **dadurch gekennzeichnet, dass** die Anode (4) derart ausgebildet wird, dass diese die Hohlkathode (1) zumindest elektronenaustrittsseitig umschließt, wobei die Stärke des Magnetfeldes (6) so hoch eingestellt wird, dass nach dem Zünden der Bogenentladung durch Verringern des Flusses (7) eines die Hohlkathode (1) durchströmenden Gases die Plasmadichte in der Vakuumarbeitskammer erhöht wird.

2. Verfahren nach Anspruch 1, **dadurch gekennzeichnet, dass** das Magnetfeld (6) mit einer Stärke von mindestens 1 kA/m, vorzugsweise von mindestens 1,0 kA/m ausgebildet wird.

3. Verfahren nach einem der vorhergehenden Ansprüche, **dadurch gekennzeichnet, dass** der Gasfluss (7) durch die Hohlkathode (1) auf unter 40 sccm, vorzugsweise auf unter 20 sccm verringert wird.

4. Verfahren nach einem der vorhergehenden Ansprüche, **dadurch gekennzeichnet, dass** als Gas ein Inertgas, vorzugsweise Argon, verwendet wird.

5. Verfahren nach einem der vorhergehenden Ansprüche, **dadurch gekennzeichnet, dass** neben dem Gasfluss (7) durch die Hohlkathode (1) ein zweiter Gasfluss in die Vakuumkammer aufrechterhalten wird, wobei ein Inertgas oder/und ein Reaktivgas Bestandteil des zweiten Glasfluss ist/sind.

6. Verfahren nach einem der vorhergehenden Ansprüche, **dadurch gekennzeichnet, dass** in der Vakuumkammer ein erstes Material mittels einer Magnetroneinrichtung zerstäubt wird oder/und ein zweites Material verdampft wird.

## Claims

1. Method for generating a plasma (9) and for increasing the density of a plasma (9) in a vacuum working chamber, in which an arc discharge is generated between a hollow cathode (1) and an anode (4), and the hollow cathode (1) is arranged in a magnetic field (6) which, at least in a region penetrating the hollow cathode (1), is formed with field lines that extend substantially parallel to the axis of the hollow cathode, **characterized in that** the anode (4) is formed in such a way that it encloses the hollow cathode (1) at least on the side from which the electrons exit, wherein the strength of the magnetic field (6) is set to such a level that, by reducing the flow (7) of a gas flowing through the hollow cathode (1), the plasma density in the vacuum working chamber is increased after the ignition of the arc discharge.

2. Method according to Claim 1, **characterized in that** the magnetic field (6) is formed with a strength of at least 1 kA/m, preferably of at least 10 kA/m.

3. Method according to one of the preceding claims, **characterized in that** the gas flow (7) through the hollow cathode (1) is reduced to below 40 sccm, preferably to below 20 sccm.

4. Method according to one of the preceding claims, **characterized in that** an inert gas, preferably argon, is used as the gas.

5. Method according to one of the preceding claims, **characterized in that**, apart from the gas flow (7) through the hollow cathode (1), a second gas flow into the vacuum chamber is maintained, wherein an inert gas and/or a reactive gas is/are a constituent part of the second gas flow.

6. Method according to one of the preceding claims, **characterized in that** a first material is atomized by means of a magnetron device and/or a second material is vaporized in the vacuum chamber.

## Revendications

1. Procédé de génération d'un plasma (9) et d'augmentation de la densité d'un plasma (9) dans une chambre de travail à vide, dans laquelle une décharge à arc entre une cathode creuse (1) et une anode (4) est générée et la cathode creuse (1) est disposée dans un champ magnétique (6) qui est réalisé au moins dans une région traversant la cathode creuse (1) avec des lignes de champ qui s'étendent essentiellement parallèlement à l'axe de la cathode creuse, **caractérisé en ce que** l'anode (4) est réalisée de telle sorte qu'elle entoure la cathode creuse (1) au moins du côté de la sortie des électrons, l'intensité du champ magnétique (6) étant ajustée de manière suffisamment élevée pour qu'après l'allumage de la décharge à arc par réduction du flux (7) d'un gaz s'écoulant à travers la cathode creuse (1), la densité plasmatique soit augmentée dans la chambre de travail à vide.

2. Procédé selon la revendication 1, **caractérisé en ce que** le champ magnétique (6) est réalisé avec une intensité d'au moins 1 kA/m, de préférence d'au moins 10 kA/m.

3. Procédé selon l'une quelconque des revendications précédentes, **caractérisé en ce que** le flux de gaz (7) à travers la cathode creuse (1) est réduit à moins de 40 sccm, de préférence à moins de 20 sccm.

4. Procédé selon l'une quelconque des revendications précédentes, **caractérisé en ce que** l'on utilise en tant que gaz un gaz inerte, de préférence de l'argon.

5. Procédé selon l'une quelconque des revendications précédentes, **caractérisé en ce qu'**en plus du flux de gaz (7) à travers la cathode creuse (1), un deuxième flux de gaz est maintenu dans la chambre à vide, un gaz inerte et/ou un gaz réactif faisant partie du deuxième flux de gaz.

6. Procédé selon l'une quelconque des revendications précédentes, **caractérisé en ce qu'**un premier matériau est pulvérisé au moyen d'un dispositif à magnétron et/ou un deuxième matériau est évaporé dans la chambre à vide.
